# EUROPEAN PATENT APPLICATION

(11) **EP 4 270 458 A1**
(43) Date of publication of application: **01.11.2023**
(21) Application number: 23168721.1
(22) Date of filing: 19.04.2023
(51) Int. Cl.: H01L 21/74, H01L 21/768, H01L 23/48, H01L 23/528

(54) **VIA CONNECTING THE FRONT SIDE OF A SEMICONDUCTOR DEVICE TO A BACK SIDE POWER DISTRIBUTION NETWORK AND CORRESPONDING METHOD**

(30) Priority: 26.04.2022 US 202263335073 P; 10.08.2022 US 202217885237
(71) Applicant: Samsung Electronics Co., Ltd., Suwon-si, Gyeonggi-do 16677 (KR)
(72) Inventor: KIM, Eun Sung, San Jose, CA, 95134 (US); BAEK, Jaejik, San Jose, CA, 95134 (US); HONG, Wonhyuk, San Jose, CA, 95134 (US); JUNG, Myunghoon, San Jose, CA, 95134 (US); LEE, Jongjin, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device that includes: at least one transistor, a front side structure, and a back side structure, the front side structure being disposed opposite to the back side structure with respect to the transistor; and a front via formed at a side of the transistor and connecting the front side structure to the back side structure, wherein the front via is formed in a via hole formed of a lower via hole and an upper via hole vertically connected to each other, and wherein the via hole has a bent structure at a side surface thereof where the lower via hole is connected to the upper via hole.

## Description

### BACKGROUND

### 1. Field

Apparatuses and methods consistent with example embodiments of the disclosure relate to formation of a via structure that connects a front side structure of semiconductor device to a back side power distribution network (BSPDN) using a sacrificial via structure.

### 2. Description of the Related Art

A BSPDN including a buried power rail (BPR) disposed at a back side of a semiconductor device including one or more transistors has been introduced to address routing complexity at a front side of the semiconductor device. Here, the front side of the semiconductor device includes back-end-of-line (BEOL) structures and middle-of-line (MOL) structures of one or more transistors such as fin field-effect transistor (FinFET) and/or nanosheet transistor (or multi-bridge channel field-effect transistor (MBCFET^{™})).

However, the BSPDN has a challenge in forming a via structure, referred to as "front via", that connects the BSPDN structure such as a BPR with a front side structure such as a middle-of-line (MOL) structure, for example, as a source/drain region contact plug of a transistor, because of a high aspect ratio, e.g., 1:20, of the front via in the nanoscale semiconductor device. For example, it is very difficult to pattern and/or etch a via hole for the high-aspect-ratio front via, and, even if the via hole is formed, filling the via hole with a via material(s) may not be sufficient or complete, only to generate a void at a bottom portion of the via hole, which may deteriorate connection performance of the front via formed therein.

Thus, there is demand of a BSPDN-based semiconductor device structure having an improved front via structure addressing the above problems and a method of manufacturing the same.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

The disclosure is directed to a semiconductor device in which a back side structure such as a back side power distribution network (BSPDN) structure is connected to a front side structure such as a source/drain region contact plug through an improved front via structure.

According to an embodiment, there is provided a semiconductor device which may include: at least one transistor, a front side structure, and a back side structure, the front side structure being disposed opposite to the back side structure with respect to the transistor; and a front via formed at a side of the transistor and connecting the front side structure to the back side structure, wherein the front via is formed in a via hole formed of a lower via hole and an upper via hole vertically connected to each other, and wherein the via hole has a bent structure at a side surface thereof where the lower via hole is connected to the upper via hole.

According to an embodiment, the front side structure may be a source/drain region contact plug formed on a source/drain region of the transistor, and the back side structure is a BSPDN structure such as a buried power rail (BPR).

According to an embodiment, a height of the lower via hole and a height of the upper via holes may be substantially equal to each other, or the lower via hole has a higher aspect ratio than the upper via hole.

According to an embodiment, a bottom width of the upper front via may be smaller than a top width of the lower front via.

According to an embodiment, there is provided a semiconductor device which may include: at least one transistor, a front side structure, and a back side structure, the front side structure being disposed opposite to the back side structure with respect to the transistor; and a front via formed at a side of the transistor and connecting the front side structure to the back side structure, wherein the front via is formed in a via hole formed of a lower via hole and an upper via hole vertically connected to each other, and wherein a connection surface is formed between the lower front via and the upper front via.

According to an embodiment, a connection surface may include a silicide layer.

According to embodiments, there is provided a method of manufacturing a semiconductor device, which may include: (a) providing at least one transistor structure formed on a substrate at a side of which an isolation structure is formed; (b) forming an ancillary layer on the transistor stack; (c) forming a preliminary via hole at a side of the transistor structure, the preliminary via hole vertically penetrating the ancillary layer and the isolation structure; (d) removing the ancillary layer at a side of the transistor structure, leaving a lower portion of the preliminary via hole in the isolation structure; (e) filling the lower portion of the preliminary via hole with a sacrificial via structure; (f) forming an isolation layer on the transistor structure; (g) forming an upper via hole penetrating the isolation layer at a side of the transistor structure, and forming a lower via hole by removing the sacrificial via structure; (h) forming the upper front via in the upper via hole, and forming a lower front via in the lower via hole; and (i) forming a front side structure of the semiconductor device on the transistor structure to be connected to the upper front via, and forming a back side structure of the semiconductor device to be connected to the lower front via.

### BRIEF DESCRIPTION OF DRAWINGS

Example embodiments of the disclosure will be more clearly understood from the following detailed description taken in conjunction with the accompanying drawings in which:
FIG. 1 illustrates a cross-section view of a semiconductor device in which at least one transistor is connected to a back side power rail (BPR) in a back side power delivery network (BSPDN) structure, according to an embodiment;
FIGS. 2A to 2L illustrate cross-section views of a method for manufacturing a BSPDN-based semiconductor device, according to embodiments;
FIG. 3 illustrates a flowchart of the method described in reference to FIGS. 2A to 2L, according to embodiments;
FIG. 4 illustrates a cross-section view of a semiconductor device in which at least one transistor is connected to a BPR in a BSPDN structure, according to an embodiment;
FIGS. 5A to 5F illustrate cross-section views of another method for manufacturing a semiconductor device including a BSPDN-based semiconductor device, according to embodiments;
FIG. 6 illustrates a flowchart of the method described in reference to FIGS. 5A to 5F, according to embodiments; and
FIG. 7 is a schematic block diagram illustrating an electronic device including one or more BSPDN-based semiconductor devices as shown in FIGS. 1 and 4, according to an example embodiment.

### DETAILED DESCRIPTION OF EMBODIMENTS

The embodiments described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, a material or materials forming a metal pattern, a via or super via may not be limited to metals of which examples are taken herein as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "upper," "lower," "top," "bottom," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is flipped upside town or turned over, elements described as "below" or "beneath" other elements would then be oriented "above" the other elements, and a "top" or "upper" surface of an element would be a "bottom" or "lower" surface of the element. Thus, for example, the term "below" can encompass both an orientation of above and below, and the term "top" can encompass both a position of top and bottom, subject to the corresponding situation. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b, and c" should be understood as including only a, only b, only c, both a and b, both a and c, both b and c, or all of a, b, and c.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional illustrations that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing, unless a specific shape or form is described. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present inventive concept. Further, in the drawings, the sizes and relative sizes of layers and regions may be exaggerated for clarity.

It will be also understood that the term "transistor" may refer to a semiconductor device including a channel structure, a gate structure and source/drain regions on a substrate, while the term "transistor structure" may refer to the "transistor" or an intermediate semiconductor device structure in which the channel structure, the gate structure and the source/drain regions are not completed on the substrate.

For the sake of brevity, some conventional elements of a transistor, that is, a front-end-of-line (FEOL) structure, and an interconnect structure of the transistor, that is, a back-end-of-line (BEOL) structure and a middle-of-line (MOL) structure may or may not be described in detail herein or shown in the drawings. For example, a barrier metal line layered in a trench or a via hole where a metal pattern or a via (e.g., a front via in this disclosure) is filled therein, an etch stop layer used for forming the trench or the via hole, and a bonding layer used for bonding two layers may not be described or shown in the drawings. Further, an isolation layer which is not related to the disclosure herein may also be omitted for brevity purposes.

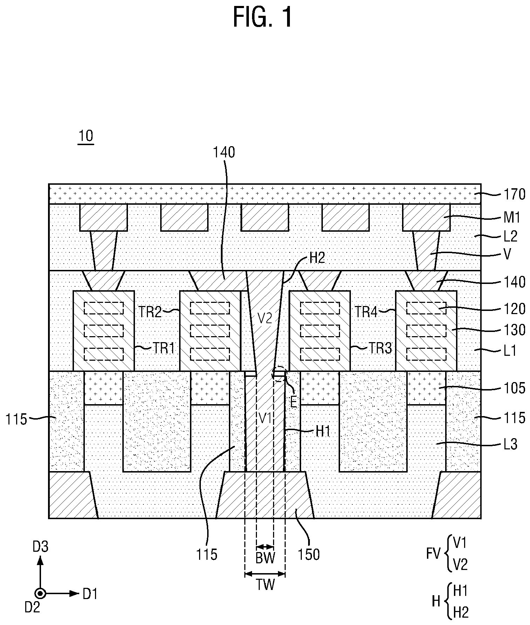

FIG. 1 illustrates a cross-section view of a semiconductor device in which at least one transistor is connected to a back side power rail (BPR) in a back side power delivery network (BSPDN) structure, according to an embodiment.

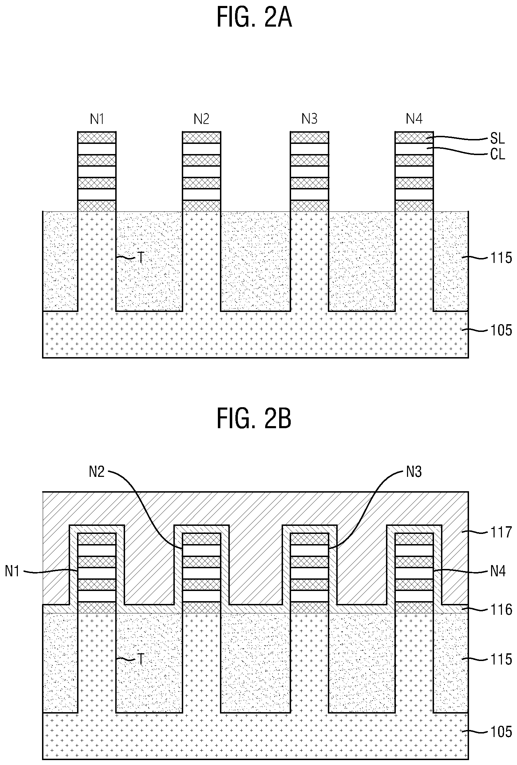

It is understood here that FIG. 1 (also FIGS. 2A-2L) shows a cross-section of a semiconductor device in D1 direction, which is a channel-width direction, at a source/drain region of a transistor, and thus, a gate structure of each of transistor surrounding a channel structure behind the source/drain region is not shown in the drawings. D2 direction perpendicular to D1 direction is a channel-length direction in which channels, e.g., nanosheet layers or fin structures, are extended between source/drain regions of each transistor.

Referring to FIG. 1, a semiconductor device 10 may include a plurality of transistors TR1-TR4 formed on respective substrates 105 which are isolated from one another by a shallow trench isolation (STI) structure 115. Each of the transistors TR1-TR4 includes a channel structure 120 and a source/drain region 130 on a corresponding substrate 105. The source/drain region 130 is connected to a source/drain region contact plug 140 as an MOL structure of the semiconductor device 10 disposed on a front side thereof. The channel structure 120 is indicated in FIG. 1 by dashed lines as this structure is behind the source/drain region 130. Although not shown, a gate contact plug may be or included in another MOL structure.

The channel structure 120 may include a plurality of nanosheet channel layers to form the transistors TR1-TR4 as nanosheet transistors in the present embodiment as shown in FIG. 1. However, the channel structure 120 may have different configurations such as one or more vertical fin structures that may form the transistors TR1-TR4 as fin field-effect transistors (FinFETs), according to an embodiment.

The substrate 105 may be formed of a semiconductor material such as silicon (Si), doped or undoped. The substrate 105 may be a semiconductor-on-insulator (SOI) substrate including a semiconductor material formed on an insulator layer such as a buried oxide (BOX) layer which may facilitate formation of buried power rails (BPR). The source/drain region 130 may be epitaxially grown from the substrate 105 and/or the channel structures 120, and thus, may include a similar semiconductor material as the substrate 105, and may be doped with impurities such as boron (B), gallium (Ga), indium (In), aluminum (Al), phosphorus (P), arsenic (As), antimony (Sb), etc. The source/drain region contact plug 140 may be formed of a metal or metal compound including at least one of copper (Cu), titanium (Ti), tantalum (Ta), aluminum (Al), tungsten (W), cobalt (Co), molybdenum (Mo), ruthenium (Ru), etc. The STI structure 115 may be formed of one or more low-x materials such as silicon oxide (e.g., SiO), silicon nitride (e.g., SiN), silicon oxynitride (e.g., SiON), not being limited thereto. The low-x material may have a dielectric constant (κ value) that is about 3.9 or less.

According to an embodiment, the semiconductor device 10 may also include a back side structure such as a back side power distribution network (BSPDN) structure including plurality of BPRs including a BPR 150. The semiconductor device 10 may also include a front via FV through which a positive or negative voltage is supplied to a front side structure of the semiconductor device, e.g., the source/drain region contact plug 140 of the transistor TR2, as shown in FIG. 1. Although not shown, the voltage may also be supplied to a gate plug of at least one of the transistors TR1, TR3 and TR4 through another BPR structure and another front via of the semiconductor device 10. The BPR 150 and the front via FV may be formed of a material(s) the same as or similar to the source/drain region contact plug 140 described above.

According to an embodiment, a high-aspect via hole H in which the front via FV is contained may be formed of a lower via hole H1 and an upper via hole H2 vertically connected to each other, that is, lower and upper portions of the via hole. Accordingly, the front via FV may be formed of a lower front via V1 and an upper front via V2 vertically connected to each other, that is, lower and upper portions of the front via FV

According to an embodiment, an aspect ratio of each of the lower via hole H1 and the upper via hole H2 may be about a half of the high aspect ratio of the via hole H to facilitate a via hole etching operation and a metal-fill operation to be described later. However, the lower via hole H1 may have a lower aspect ratio than the upper via hole H2, according to an embodiment. This is because, as will be described later in a method of manufacturing the semiconductor device 10 in reference to FIGS. 2A-2L, the lower via hole H1 may be formed by applying two different etching operations, a width or an average width of the lower via hole H1 may be greater than that of the upper via hole H2. Accordingly, the lower front via V1 may have a greater width or average width than the upper front via V2 to lower the aspect ratio. Still, heights of the two via holes H1-H2 may be substantially equal to each other, and heights of the two vias V1-V2 may also be substantially equal to each other.

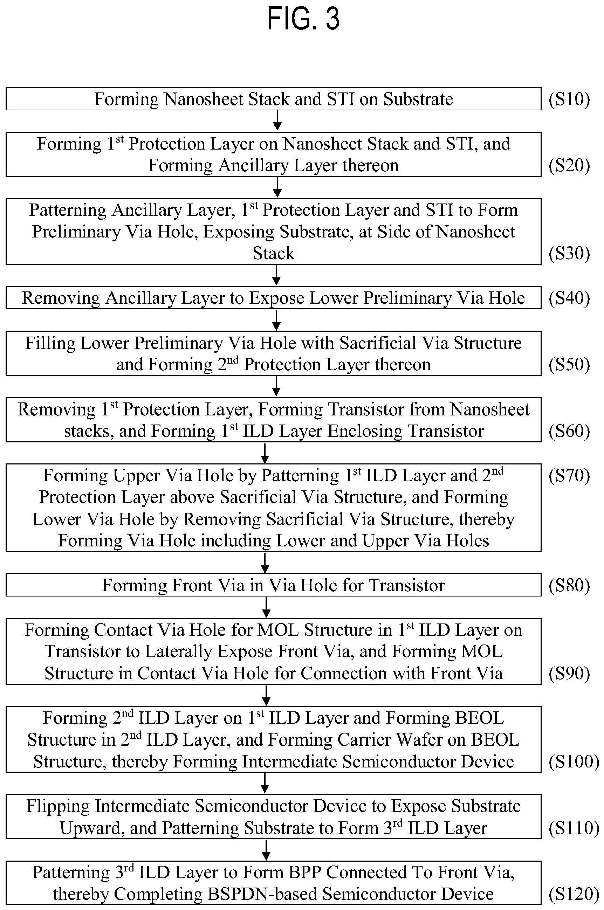

As will be described later in the descriptions of a method of manufacturing the semiconductor device 10 in reference to FIGS. 3A-3L, the lower via hole H1 and the upper via hole H2 may be formed separately at different steps. Thus, even if these two via holes are vertically connected, a portion of a side surface of the via hole H where these two via holes are connected to each other may not be as straight as a side surface of each of these two via holes H1-H2, and instead, may have a bent (or step) structure E, for example, at the lower-left edge and/or the lower-right edge of the upper via hole H1. This may be at least because a top width (or diameter) and a bottom width (or diameter) of a via hole may be different from each other. Thus, a bottom width BW of the upper via hole H2 and a top width TW of the lower via hole H1 may not be equal to each other as shown in FIG. 1. However, even if the bottom width BW and the top width TW are equal to or substantially equal to each other, a bent structure may be formed at the connected surface of the via hole H.

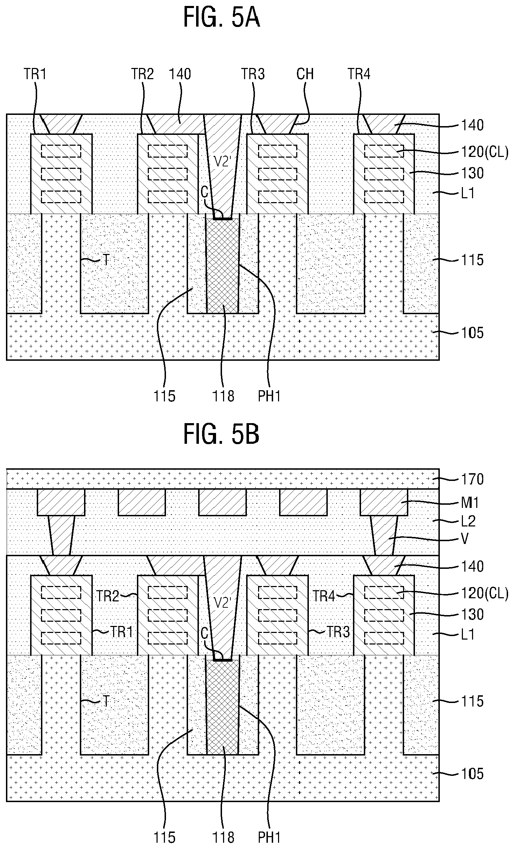

In the meantime, as will be described later in the descriptions of a method of manufacturing the semiconductor device 10 in reference to FIGS. 5A-5F, the lower and upper front vias V1 and V2 may also be formed at different steps. In this case, there may be a connection surface between these two via structures, according to an embodiment. This connection surface may be a combination of a top surface of the lower front via V1 and a bottom surface of the upper front via V2.

Moreover, as will be also described later, each of the lower and upper via holes H1-H2 has a lower aspect ratio compared to one continuously formed via hole for the related-art front via. Thus, these two vertically connected via holes H1-H2 may be easier and simpler to form than the related art via hole, and further, the risk of void generation in the via holes H1- H2 may be reduced.

The semiconductor device 10 may also include a BEOL structure including a plurality of metal lines M1 extended to D2 direction and vias V The metal lines M1 respectively connected to the source/drain region contact plugs 140 of the transistors TR1 and TR4 through respective vias V may transmit or receive internal routing signals to or from other circuit elements (not shown) of the semiconductor device 10. The metal lines M1 and vias V may also be formed of the same as or similar to the material(s) forming the source/drain region contact plug 140 described above. However, according to an embodiment, these metal structures, that is, the source/drain region contact plugs 140, BPR 150, front via FV, metal lines M1 and vias V may have different metal compositions.

1^{st} to 3^{rd} interlayer dielectric (ILD) layers L1-L3 may be provided in the semiconductor device 10. The 1^{st} ILD layer L1 may isolate the source/drain regions 130 of the transistors TR1-TR4 from one another. The 2^{nd} ILD layer L2 may isolate the metal lines M1 and vias V from one another, and the 3^{rd} ILD layer L3 may isolate the BPRs 150 from one another. The ILD layers L1-L3 may be formed of the same or similar material forming the STI structure 115.

The semiconductor device 10 may also include a carrier wafer 170 according to an embodiment. The carrier wafer 170 may be formed of glass, ceramic, silicon, or the like that may provide structural support to the semiconductor device 10. The carrier wafer 170 may be substantially free of an active device (e.g., transistor) or a passive device (e.g., PN junction device).

In the semiconductor device 10 shown in FIG. 1, the via hole H and the front via FV are formed to connect an MOL structure, e.g., a source/drain region contact plug 140 to the BPR 150. However, the disclosure is not limited thereto. According to embodiments, the via hole H and the front via FV may also be formed to connect another BSPDN structure to another front side structure of the semiconductor device 10.

Herebelow, a method of manufacturing a semiconductor device corresponding to the semiconductor device 10 including the front via FV will be described.

FIGS. 2A to 2L illustrate cross-section views of a method for manufacturing a BSPDN-based semiconductor device, according to embodiments. FIG. 3 illustrates a flowchart of the method described in reference to FIGS. 2A to 2L, according to embodiments.

The BSPDN-based semiconductor device manufactured by the method described below in reference to FIGS. 2A to 2L and FIG. 3 may be or correspond to the semiconductor device 10 shown in FIG. 1. Thus, materials forming or included in various structures or elements of intermediate or completed semiconductor device structures described below may be the same materials of those structures or elements of the semiconductor device 10, and duplicate descriptions thereof may be omitted herebelow. The same reference numbers used for describing the semiconductor device 10 in FIG. 1 may be used herebelow.

Referring to FIG. 2A, at least one nanosheet stack may be formed on a substrate at a side of which an STI structure is formed (S10 in FIG. 3).

According to an embodiment, a plurality of nanosheet layers including sacrificial layers SL and channel layers CL may be epitaxially grown from the substrate 105, and patterned through, for example, photolithography and etching (dry and/or wet etching), to obtain a plurality of nanosheet stacks N1-N4. The sacrificial layers SL are termed as such because these layers will be removed and replaced by a gate structure for a transistor to be formed from each of the nanosheet stacks N1-N4. The channel layers are termed as such because these layers will form a channel structure of each of the nanosheet stacks N1-N4. For example, the sacrificial layers SL may be formed of a silicon germanium (SiGe) compound consisting of 35% of Ge and 65% of Si, and the channel layers CL may be formed of silicon (Si).

The STI structure 115 may be deposited in a plurality of trenches T formed between the nanosheet stacks N1-N4. These trenches T may be formed when the nanosheet stacks N1-N4 are patterned based on respective hard mask structures (not shown) used in the photolithography and etching operation. The deposition technique used for the formation of the STI structure 115 may be physical vapor deposition (PVD), chemical vapor deposition (CVD), plasma enhanced CVD (PECVD), sputtering and/or electroplating, not being limited thereto.

Referring to FIG. 2B, a 1^{st} protection layer may be formed on the nanosheet stack and a top surface of the STI structure, and an ancillary layer for patterning a via hole may cover the nanosheet stack and STI structure with the protection layer thereon (S20 in FIG. 3).

According to an embodiment, a 1^{st} protection layer 116 formed of silicon nitride (e.g., SiN) may be conformally layered on top and side surfaces of the nanosheet stacks N1-N4 and a top surface of the STI structure 115 through, for example, a thin film deposition technique such as atomic layer deposition (ALD). An ancillary layer 117 such as spin-on-hardmask (SOH) structure may be deposited to cover the nanosheet stack N1-N4 and the STI structure 115 protected by the 1^{st} protection layer 116 formed thereon, and planarized to facilitate a follow-on photolithography and etching operation.

The ancillary layer 117 may include carbon or a carbon polymer that may enable formation of a more accurate high-aspect-ratio trench or via hole than silicon, silicon oxide or silicon nitride forming the substrate 105, the ILD layer L1-L3 or the STI structure 115, according to an embodiment.

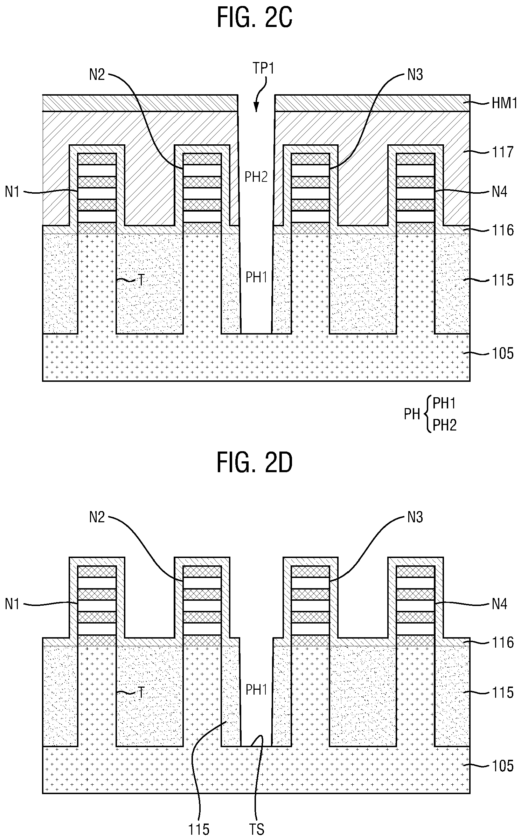

Referring to FIG. 2C, the ancillary layer, the 1^{st} protection layer and the STI structure at a target position, where a front via is to be formed, may be etched to form a preliminary via hole exposing a surface of the substrate at a side of the nanosheet stack (S30 in FIG. 3).

According to an embodiment, a top surface of the ancillary layer 117 may be masked by a hard mask structure HM1 except a target position TP1 below which the front via FV is to be formed at a side of a selected nanosheet stack N2 among the nanosheet stacks N1-N4. Preliminary etching (e.g., dry and/or wet etching) may be performed from the top surface of the ancillary layer 117 at the target position TP1 through the 1^{st} protection layer 116 and the STI structure 115 to reach a surface TS of the substrate 105 to form a preliminary via hole PH having a high aspect ratio.

By this etching operation, the preliminary via hole PH may vertically penetrate the ancillary layer 117, the 1^{st} protection layer 116 and the STI structure 115 below the target position TP1, and expose, as its bottom surface, the surface TS of the substrate 105 between the nanosheet stacks N2 and N3. Further, the preliminary via hole PH may expose, as its side surface, surfaces of the ancillary layer 117, the 1^{st} protection layer 116 and the STI structure 115 that are vertically connected to each other. The exposed surface of the STI structure 115 may form a lower preliminary via hole PH1 closed at the surface TS of the substrate 105, and the exposed surfaces of the ancillary layer 117 and the 1^{st} protection layer 116 may form an upper preliminary via hole PH2 connected to the lower preliminary via hole PH1.

The surface TS of the substrate 105 exposed through the preliminary via hole PH may be coplanar with a bottom surface of the STI structure, for example.

Here, the preliminary via hole PH formed using the ancillary layer 117 of the carbon SOH structure may, even if it has a high aspect ratio, take a more accurate via hole form compared to the related-art via hole for a front via. This is because the preliminary via hole PH penetrates the carbon-based ancillary layer 117 that may enable easier formation of the high-aspect-ration via hole as described above.

Referring to FIG. 2D, the ancillary layer may be removed from the nanosheet stack on which the 1^{st} protection layer is formed, to expose a lower preliminary via hole (S40 in FIG. 3).

According to an embodiment, the hard mask structure HM1 used for patterning the preliminary via hole PH may be stripped away from the top surface of the ancillary layer 117, and the ancillary layer 117 may be removed through, for example, a plasma ashing operation acceptable for removing the carbon-based mask structure.

As the ancillary layer 117 is removed by this ashing operation, the nanosheet stacks N1-N4 with the 1^{st} protection layer 116 thereon may be exposed again. Further, as the ancillary layer 117 is removed, the upper preliminary via hole PH2 except at a portion formed by the lateral surface of the 1^{st} protection layer 116 may also be removed, leaving only this portion of the upper preliminary via hole PH2 and the lower preliminary via hole PH1 between the nanosheet stacks N2 and N3, that is, at a side of the selected nanosheet stack N2.

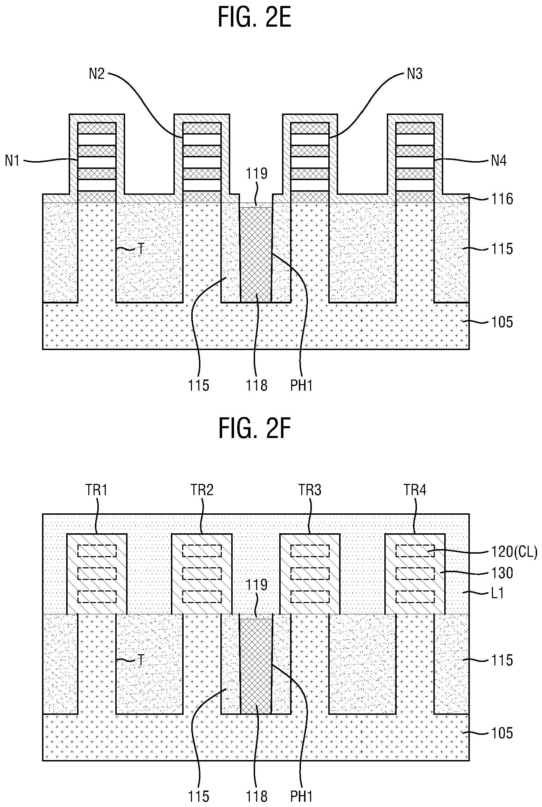

Referring to FIG. 2E, the lower preliminary via hole may be filled in with a sacrificial via structure and covered by a 2^{nd} protection layer (S50 in FIG. 3).

According to an embodiment, the lower preliminary via hole PH1 may be filled in with a sacrificial via structure 118 from the bottom surface thereof up to a predetermined level which may correspond to about a half of a height of the front via FV to be formed. For example, a top surface of the sacrificial via structure 118 at this level may be slightly below the top surface of the STI structure 115 or a bottom surface of the lowermost sacrificial layer SL of each of the nanosheet stacks N1-N4. As another example, the top surface of the sacrificial via structure 118 at this level may have a few nanometer or less below the top surface of the STI structure 115 or the bottom surface of the lowermost sacrificial layer among the sacrificial layers SL of each of the nanosheet stacks N1-N4.

According to an embodiment, the sacrificial via structure 118 may be formed of a material having etch selectivity against the STI structure 115 and the substrate 105. This is because the sacrificial via structure 118 is a structure that is to be removed by, for example, wet etching without affecting the STI structure 115 and the substrate 105 that contact the sacrificial via structure 118 in the lower preliminary via hole PH1. For example, the sacrificial via structure 118 may be formed of a silicon germanium (SiGe) compound.

PVD, CVD or PECVD, not being limited thereto, may be used to deposit the etch-selective material(s) in the lower preliminary via hole PH1 up to the predetermined level to form the sacrificial via structure 118. According to an embodiment, in case that the etch-selective material(s) is a SiGe compound, the sacrificial via structure 118 may be formed by epitaxially growing the SiGe compound from the substrate 105 forming the bottom surface of the lower preliminary via hole PH1.

A 2^{nd} protection layer 119 may be formed on a top surface of the sacrificial via structure 118 to prevent this sacrificial via structure 118 from growing upward in an epitaxy process to be performed in a next step, according to an embodiment. The 2^{nd} protection layer 119 may be formed of the same material(s) forming the STI structure 115 surrounding side surfaces of the sacrificial via structure 118 in the lower preliminary via hole PH1. However, the 2^{nd} protection layer 119 may be formed of a different material(s) that may be still able to isolate the nanosheet stacks N1-N4 from one another. According to an embodiment, the 2^{nd} protection layer 119 may be formed through, for example, atomic layer deposition (ALD), not being limited thereto, such that a top surface of the 2^{nd} protection layer 119 is coplanar with the top surface of the STI structure 115 and a bottom surface of the lowermost sacrificial layer SL among the sacrificial layers SL of each of the nanosheet stacks N1-N4.

Referring to FIG. 2F, the 1^{st} protection layer may be removed, source/drain regions may be formed at the nanosheet stack, the sacrificial layers of the nanosheet stack may be replaced by a gate structure to form a transistor, and a 1^{st} ILD layer is formed to enclose the transistor (S60 in FIG. 3).

According to an embodiment, the 1^{st} protection layer 116 may be removed from the nanosheet stacks N1-N4 and the top surface of the STI structure 115 through, for example, dry etching such as reactive ion etching (RIE), not being limited thereto.

Further, in this operation, the source/drain regions 130 may be formed at both ends of each of the nanosheet stacks N1-N4 through, for example, epitaxial-growth from the substrate 105 and/or the channel layers CL of each nanosheet stack. Here, in case that the sacrificial via structure 118 is formed of SiGe, and the source/drain regions 130 are epitaxially grown from the substrate 105 and/or the channel layers CL, the SiGe of the sacrificial via structure 118 may tend to be also epitaxially further grown. Thus, the 2^{nd} protection layer 119 may be formed on the sacrificial via structure 118 in the previous step (S50).

The sacrificial layers SL may be removed from each nanosheet stack through, for example, chemical oxide removal (COR) etching, and replaced by a gate structure (not shown) so that the channel layers CL are surrounded by the gate structure to form the channel structure 120, thereby forming the transistors TR1-TR4.

The 1^{st} ILD layer L1 may be formed on the transistors TR1-TR4 through, for example, PVD, CVD, PECVD, sputtering and/or electroplating, to cover the source/drain regions 130 thereof. According to an embodiment, the 1^{st} ILD layer L1 may be formed at the same position where the ancillary layer 117 was formed above the nanosheet stacks N1-N4 to pattern the preliminary via hole PH.

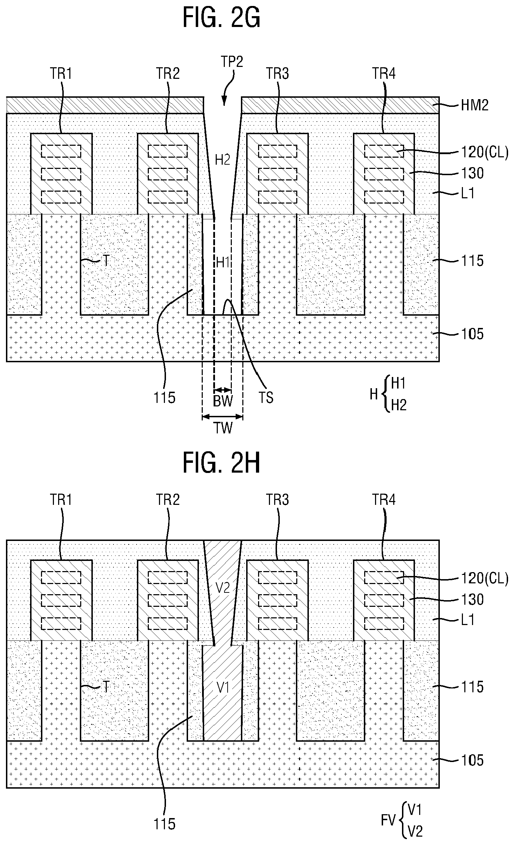

Referring to FIG. 2G, an upper via hole for an upper front via may be formed by patterning the 1^{st} ILD layer and the 2^{nd} protection layer at a position above the sacrificial via structure, and a lower via hole for a lower front via may be formed by removing the sacrificial via structure, thereby forming a via hole including the lower and upper via holes to fill in with the front via (S70 in FIG. 3).

According to an embodiment, a top surface of the 1^{st} ILD layer L1 may be masked by another hard mask structure HM2 except a target position TP2, which corresponds to the target position TP1 marked at the top surface of the ancillary layer 117 in the earlier step. Etching (e.g., dry etching and/or wet etching) may be performed from the top surface of the 1^{st} ILD layer L1 at the target position TP2 through the 1^{st} ILD layer L1, the 2^{nd} protection layer 119 and the sacrificial via structure 118 to reach the surface TS of the substrate 105 to form the via hole H having a high aspect ratio for the formation of the front via FV

According to an embodiment, the etching operation in this step may be performed at two sub-steps. In a 1^{st} sub-step, the 1^{st} ILD layer L1 and the 2^{nd} protection layer 119 may be etched through, for example, dry etching such as reactive ion etching (RIE). Since this 1^{st} sub-step etching is to form the upper via hole H2 for the upper front via V2 having a low aspect ratio, the patterning difficulty may be reduced compared to the formation of the related-art via hole for a front via having a high aspect ratio.

In a 2^{nd} sub-step, the lower via hole H1 for the lower front via V1 may be formed by removing the sacrificial via structure 118 through, for example, wet etching based on etch selectivity of the material(s) included the sacrificial via structure 118 against the material(s) included in the STI structure 115 and the substrate 105 forming the side and bottom surfaces of the lower via hole H1. In other words, while the sacrificial via structure 118 is removed by a wet etchant or solvent, the STI structure 115 and the substrate 105 may remain intact or without being affected by the wet etchant or solvent. For example, when the sacrificial via structure 118 is formed of SiGe, acetic acid (CH3COOH), hydrogen peroxide (H2O2), hydrofluoric acid (HF), or a compound thereof, not being limited thereto, may be used for the wet etchant with respect to the silicon, silicon oxide and/or silicon nitride forming the substrate 105 and the STI structure 115. Since this 2^{nd} sub-step etching is to form the lower via hole H1 also having a low aspect ratio, the patterning difficulty may be much less than in the formation of the related-art via hole for a front via.

Here, the lower via hole H1 is obtained by applying the above-described etching (wet etching) the sacrificial via structure 118 in the lower preliminary via hole PH1 formed by the preliminary etching in the previous step (S30), the lower via hole H1 may have a greater width or average width than the lower preliminary via hole PH1, according to an embodiment. This width or average width may also be greater than that of the upper via hole H2, according to an embodiment. Thus, the lower via hole H1 may have a lower aspect ratio than the upper via hole H2, according to an embodiment.

Further, since the lower and upper via holes H1-H2 may be separately formed at two different sub-steps to form the connected via hole H, there may be the bent (or step) structure E at a portion of the side surface of the via hole H where the two via holes meet, for example, at the lower-left edge and/or the lower-right edge of the upper via hole H1. Due to this bent structure, the bottom width BW of the upper via hole H2 and the top width TW of the lower via hole H1 may not be equal to each other. Further, as the upper via hole H2 is formed in the previous step (S70) by penetrating the thin 2^{nd} protection layer 119 after the 1^{st} ILD layer L1, the upper-left edge and/or the upper-right edge of the lower via hole H1 may be below the 2^{nd} protection layer 119 which is not removed by the lower via hole etching.

Referring to FIG. 2H, the via hole including the lower and upper via holes may be filled in with a via material(s) to obtain the front via for the transistor formed from the nanosheet stack (S80 in FIG. 3).

According to an embodiment, the hard mask structure HM2 used for patterning the via hole H including the lower and upper via holes H1-H2 may stripped away from the top surface of the 1^{st} ILD layer L1, and the via material(s) may be filled in the via hole H and planarized to obtain the front via FV

The via material(s) may be formed in the via hole H through, for example, CVD, PVD, or PECVD, not being limited thereto, and planarized to form the front via FV at a side of the transistor T2 formed from the selected nanosheet stack N2. After the planarization of the via material(s), a top surface of the front via FV may be coplanar with the top surface of the 1^{st} ILD layer L1 surrounding the transistors T1-T4.

According to an embodiment, the via material(s) may be filled in the lower via hole H1 to form the lower front via V1, and then may be continuously filled in in the upper via hole H2 to form the upper front via V2. Here, an upper-left edge and an upper-right edge of the lower front via V1 may be formed below the 2^{nd} protection layer 119 which is not removed by the lower via hole etching in the previous step (S70).

Since the front via FV is formed in the via hole H including the lower and upper via holes H1-H2 which are separately formed at two different sub-steps as described in the previous step (S70), the front via FV according to the present embodiment may also avoid the risk of void generation at a bottom portion of the via hole H that occurs when a via material is filled in the related-art via hole for a front via.

Further, as the lower via hole H1 has a greater width or average width than the upper via hole H2 as described in the previous step (S70), the lower front via V1 filled therein may have a greater width or average width and a higher aspect ratio than the upper front via V2, according to embodiments.

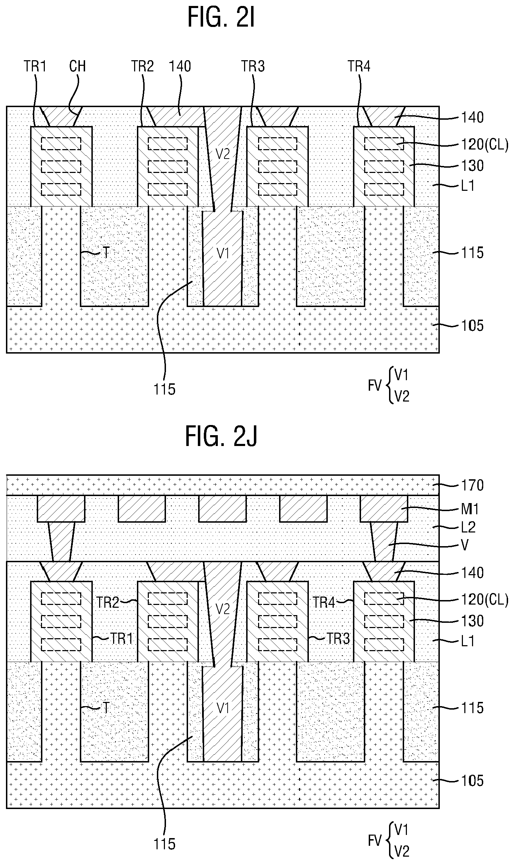

Referring to FIG. 2I, a contact via hole for an MOL structure may be patterned in the 1^{st} ILD layer on the transistor to laterally expose the front via, and the MOL structure may be formed in the contact via hole to be connected to the front via (S90 in FIG. 3).

According to an embodiment, the 1^{st} ILD layer L1 may be patterned through, for example, photolithography and etching (dry and/or wet etching), to form contact via holes CH exposing the source/drain regions 130 of the transistors TR1-TR4, respectively. At this time, the contact via hole CH exposing the source/drain region 130 of the transistor TR2 may be formed also to laterally expose the front via FV

The via material(s) may be filled in each of the contact via holes CH to form the source/drain region contact plug 140 on the source/drain region 130 of each of the transistors TR1-TR4, and planarized. Here, the source/drain region contact plug 140 filled in the contact via hole CH exposing the source/drain region 130 of the transistor T2 may be laterally connected to the front via FV Further, due to the planarization of the via material(s) filled in the contact via holes CH, top surfaces of the source/drain region contact plugs 140 may be coplanar with the top surfaces of the 1^{st} ILD layer L1 and the front via FV

Referring to FIG. 2J, a 2^{nd} ILD layer may be formed on the 1^{st} ILD layer and a BEOL structure may be formed in the 2^{nd} ILD layer, and a carrier wafer may be formed on the BEOL structure, thereby forming an intermediate semiconductor device (S 100 in FIG. 3).

According to an embodiment, a 2^{nd} ILD layer L2 may be formed on the coplanar top surfaces of the 1^{st} ILD layer L1, the front via FV and the source/drain region contact plugs 140 through, for example, PVD, CVD, PECVD, sputtering and/or electroplating. A single damascene operation and/or a dual damascene operation may be performed on the 2^{nd} ILD layer L2 thus formed to form a BEOL structures including the metal lines M1 and the vias V in the 2^{nd} ILD layer L2. In the BEOL structure, some of the metal lines M1 and vias V may be connected to the source/drain region contact plugs 140 of the transistors TR1 and TR4, respectively, as shown in FIG. 2J.

The carrier wafer 170 may be bonded to a top surface of the BEOL structure including the metal lines M1 and the vias V to form an intermediate semiconductor device.

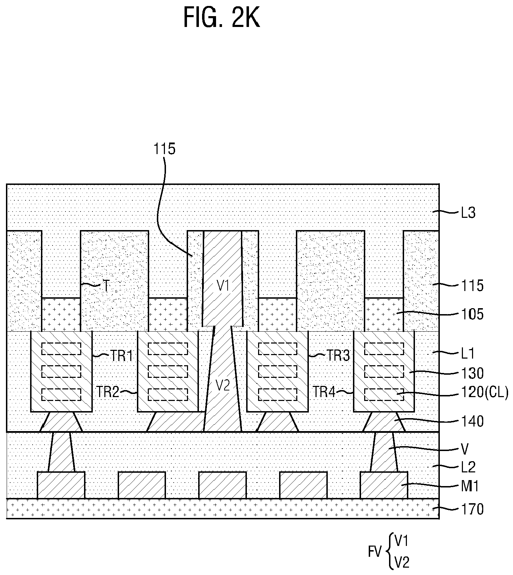

Referring to FIG. 2K, the intermediate semiconductor device obtained in the previous step may be flipped upside down to expose the substrate upward, and the substrate may be patterned and replaced by a 3^{rd} ILD layer (S110 in FIG. 3).

According to an embodiment, the intermediate semiconductor device obtained in the previous step (S100) may be flipped upside down so that a back side of the substrate 105 may be directed upward and the carrier wafer 170 may be directed downward.

At least a portion of the substrate 105 may be patterned through, for example, photolithography and etching (dry and/or wet etching), and replaced by an ILD material(s), to form the 3^{rd} ILD layer L3.

FIG. 2K shows that portions of the substrate 105 remain above the transistors TR1-TR4 between portions of the STI structure 115. However, the substrate 105 may be entirely removed to be replaced by the 3^{rd} ILD layer L3, according to an embodiment.

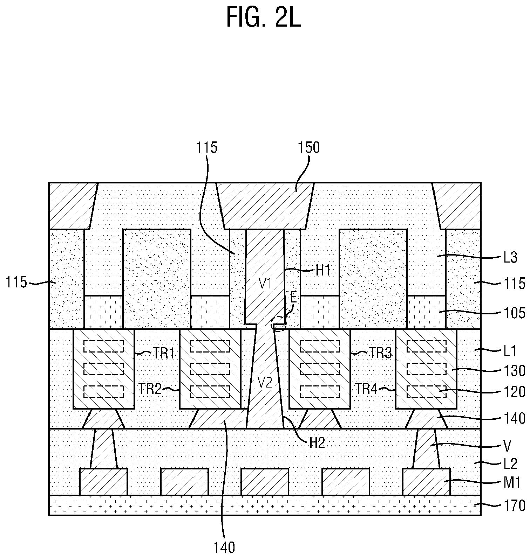

Referring to FIG. 2L, the 3^{rd} ILD layer may be patterned to form a BPR connected to the front via, thereby forming a BSPDN-based semiconductor device including the front via connected to the BPR (S120 in FIG 3).

According to an embodiment, the 3^{rd} ILD layer L3 may be patterned through, for example, photolithography and etching (dry and/or wet etching), to form a plurality of BPRs 150 for a BSPDN. The 3^{rd} ILD layer L3 may be patterned such that one of the BPRs 150 may be formed vertically above the front via FV and connected thereto.

Thus, the BSPDN-based semiconductor device 10 including the front via FV may be obtained as shown in FIG. 2L. This BSPDN-based semiconductor device 10 may be flipped upside down again as shown in FIG. 1 for further processing.

In the meantime, the via hole H formed for the front via FV in the above method may have an incomplete via structure because of the bent structure E that may be formed at the lower-left edge and/or the lower-right edge of the upper via hole H2 as shown in FIG. 2G. The bent structure E may be formed as the lower via hole H1 and the upper via hole H2 are formed respectively at different steps. This bent structure E may prevent the via material(s) from completely filling the upper-left edge or the upper-right edge of the lower via hole H1 when the via material(s) is deposited continuously in the lower via hole H1 and the upper via hole H2 at a single step to form the single-structure front via FV Thus, an alternative structure of a BSPDN-based semiconductor device and a method of manufacturing the same are described below.

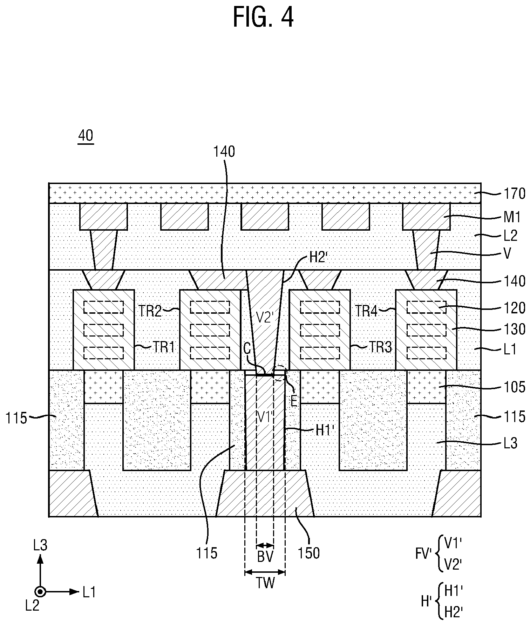

FIG. 4 illustrates a cross-section view of a semiconductor device in which at least one transistor is connected to a BPR in a BSPDN structure, according to an embodiment.

A semiconductor device 40 shown in FIG. 4 may include the same structural elements forming the semiconductor device 10. Thus, duplicate descriptions thereof are omitted herein, and only different aspects of the semiconductor device 40 are described herebelow.

According to an embodiment, a front via FV' of the semiconductor device 40 may also include a lower front via V1' and an upper front via V2' as in the semiconductor device 10 of FIG. 1. However, in addition that a lower via hole H1' and an upper via hole H2' are separately formed at different steps to form a via hole H', the lower front via V1' and the upper front via V2' may also be formed as different steps, as will be described later in reference to FIGS. 5A to 5F below. Further, a direction in which the via material(s) is filled in the lower via hole H1' may be opposite to a direction in which the via material(s) is filled in the upper via hole H2'. Thus, a connection may exist or may be formed between a bottom surface of the upper front via V2' and a top surface of the lower front via V 1', according to an embodiment.

Further, a silicide layer C may be present at a connection surface formed between a bottom surface of the upper front via V2' and a top surface of the lower front via V1' contacting each other in the via hole H', according to an embodiment. The silicide layer C may include cobalt, titanium, tungsten or a combination thereof, not being limited thereto.

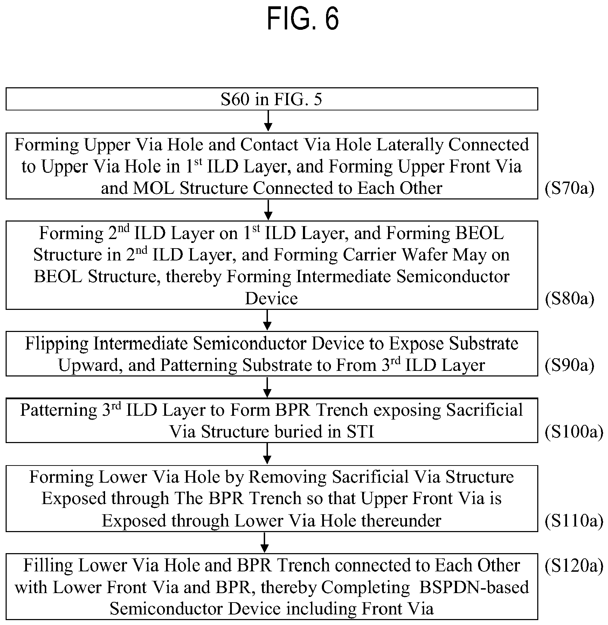

FIGS. 5A to 5F illustrate cross-section views of another method for manufacturing a semiconductor device including a BSPDN-based semiconductor device, according to embodiments. FIG. 6 illustrates a flowchart of the method described in reference to FIGS. 5A to 5F, according to embodiments.

The BSPDN-based semiconductor device manufactured by the method described below in reference to FIGS. 5A to 5F and FIG. 6 may be or correspond to the semiconductor device 40 shown in FIG. 4. Thus, materials forming or included in various structures or elements of intermediate or completed semiconductor device structures described below may be the same materials of those structures or elements of the semiconductor device40, and duplicate descriptions thereof may be omitted herebelow. The same reference numbers used for describing the semiconductor device 40 in FIG. 4 may be used herebelow.

In addition, the method of manufacturing the semiconductor device 4 may be the same as or similar to that of manufacturing the semiconductor device 10 until the step described in reference to FIG. 2F (S60 in FIG. 3). Thus, the method of manufacturing the semiconductor device 40 begins thereafter.

Referring to FIG. 5A, an upper via hole for an upper front via and a contact via hole for an MOL structure laterally connected to the upper via hole may be patterned in the 1^{st} ILD layer, and the upper front via and the MOL structure may be filled therein, respectively, to be connected to each other (S70a in FIG. 6).

According to an embodiment, the 1^{st} ILD layer L1 may be patterned through, for example, photolithography and etching (dry and/or wet etching), to form the upper via hole H2' exposing the sacrificial via structure 118 in the preliminary lower via hole PH1 thereunder and to form contact via holes CH respectively exposing the source/drain regions 130 of the transistors TR1-TR4. At this time, the contact via hole CH exposing the source/drain region 130 of the transistor TR2 may be formed to be laterally connected to the upper via hole H2'.

The via material(s) may be filled in the upper via hole H2' and the contact via holes CH to form the upper front via V2' and the source/drain region contact plug 140 on the source/drain regions 130 of the transistors TR1-TR4, respectively, and planarized. Here, the source/drain region contact plug 140 filled in the contact via hole CH exposing the source/drain region 130 of the transistor T2 may be laterally connected to the upper front via V2'. Further, due to the planarization of the via material(s) filled in the upper via hole H2' and the contact via holes CH, top surfaces of the upper front via V2' and the source/drain region contact plugs 140 may be coplanar with the top surfaces of the 1^{st} ILD layer L 1.

In the meantime, when the upper via hole H2' is formed and filled with the via material(s) to form the upper front via V2' contacting the exposed sacrificial via structure 118 thereunder, a bottom surface of the upper front via V2' and/or a top surface of the exposed sacrificial via structure 118 may be silicided, thereby forming a silicide layer C between the upper front via V2' and the sacrificial via structure 118. This silicidation may occur as the upper front via V2' may include a metal or metal compound such as copper (Cu), titanium (Ti), tantalum (Ta), aluminum (Al), tungsten (W), cobalt (Co), molybdenum (Mo), ruthenium (Ru), etc., while the sacrificial via structure 118 may include a silicon compound such as SiGe.

Referring to FIG. 5B, a 2^{nd} ILD layer may be formed on the 1^{st} ILD layer and a BEOL structure may be formed in the 2^{nd} ILD layer, and a carrier wafer may be formed on the BEOL structure, thereby forming an intermediate semiconductor device (S80a in FIG. 6).

According to an embodiment, a 2^{nd} ILD layer L2 may be formed on the coplanar top surfaces of the 1^{st} ILD layer L1, the upper front via V2' and the source/drain region contact plugs 140 through, for example, PVD, CVD, PECVD, sputtering and/or electroplating. A single damascene operation and/or a dual damascene operation may be performed on the 2^{nd} ILD layer L2 thus formed to form a BEOL structures including the metal lines M1 and the vias V in the 2^{nd} ILD layer L2. In the BEOL structure, some of the metal lines M1 and vias V may be connected to the source/drain region contact plugs 140 of the transistors TR1 and TR4, respectively, as shown in FIG. 5B.

The carrier wafer 170 may be bonded to a top surface of the BEOL structure including the metal lines M1 and the vias V to form an intermediate semiconductor device.

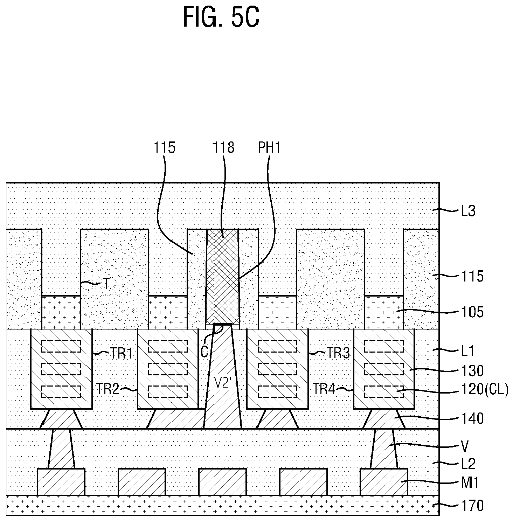

Referring to FIG. 5C, the intermediate semiconductor device obtained in the previous step may be flipped upside down to expose the substrate upward, and the substrate may be patterned and replaced by a 3^{rd} ILD layer (S90a in FIG. 6).

According to an embodiment, the intermediate semiconductor device obtained in the previous step (S80a) may be flipped upside down so that a back side of the substrate 105 may be directed upward and the carrier wafer 170 may be directed downward.

At least a portion of the substrate 105 may be patterned through, for example, photolithography and etching (dry and/or wet etching), and replaced by an ILD material(s), to form the 3^{rd} ILD layer L3.

FIG. 5C shows that portions of the substrate 105 remain above the transistors TR1-TR4 between portions of the STI structure 115. However, the substrate 105 may be entirely removed to be replaced by the 3^{rd} ILD layer L3, according to an embodiment.

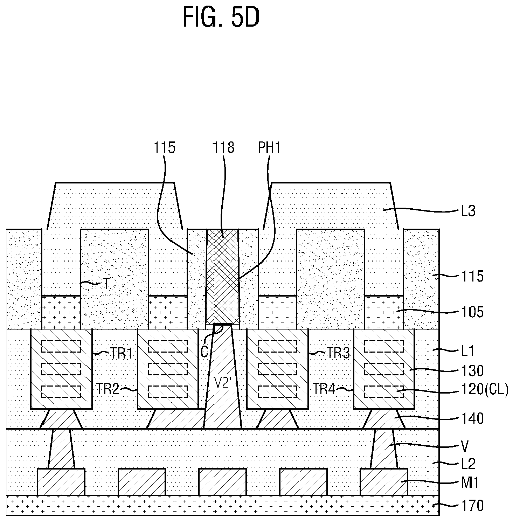

Referring to FIG. 5D, the 3^{rd} ILD layer may be patterned to form a BPR trench exposing the sacrificial via structure buried in the STI structure (S100a in FIG. 6).

According to an embodiment, the 3^{rd} IL layer 3 may be patterned through, for example, photolithography and etching (dry and/or wet etching), to form a plurality of BPR trenches BT such that one of the BPR trenches BT for the BPR 150 may expose a bottom surface (now top surface in the flipped structure) of the sacrificial via structure 118.

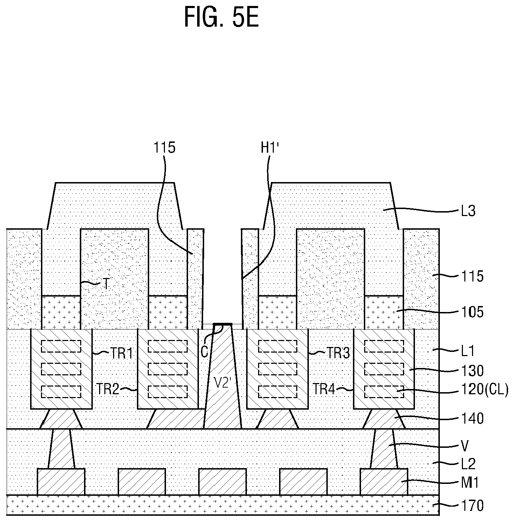

Referring to FIG. 5E, the lower via hole may be formed by removing the sacrificial via structure exposed through the BPR trench so that the upper front via is exposed through the lower via hole thereunder (S10a in FIG. 6).

According to an embodiment, the lower via hole H1' for the lower front via V1' may be formed by removing the sacrificial via structure 118 through, for example, wet etching based on etch selectivity of the material(s) included in the sacrificial via structure 118 against the material(s) included in the STI structure 115 forming the side surface of the lower via hole H1'. In other words, while the sacrificial via structure 118 is removed by a wet etchant or solvent, the STI structure 115 may remain intact or without being affected by the wet etchant or solvent. For example, when the sacrificial via structure 118 is formed of SiGe, acetic acid (CH3COOH), hydrogen peroxide (H2O2), hydrofluoric acid (HF), or a compound thereof, not being limited thereto, may be used for the wet etchant with respect to the silicon oxide or silicon nitride forming the STI structure 115. Since this etching operation is to form the upper via hole H2' having a low aspect ratio, the patterning difficulty may be much less than in the formation of the related-art via hole for a front via.

As the sacrificial via structure 118 is removed by the above etching operation, the silicide layer C, if any, formed on the top surface (now bottom surface) of the sacrificial via structure 118 and/or the bottom surface of the upper front via V2' may be exposed, according to an embodiment.

Further, due to the preliminary etching applied to the lower via hole H1' in the previous step (S30), the lower via hole H1' may have a greater width or average width than the lower preliminary via hole PH1, according to an embodiment. This width or average width may also be greater than that of the upper via hole H2', according to an embodiment. Thus, the lower via hole H1' may have a greater aspect ratio than the upper via hole H2', according to an embodiment.

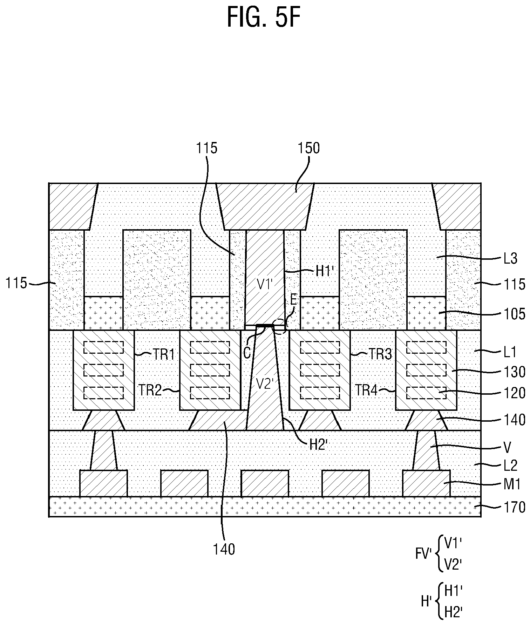

Referring to FIG. 5F, the lower via hole and the BPR trench connected to each other may be filled in with the lower front via and the BPR, respectively, thereby obtaining a BSPDN-based semiconductor device including the front via connected to the BPR (S120a in FIG 6).

According to an embodiment, the lower via hole H1' may be filled in with the via material(s) to form the lower front via V1' connected to the previously formed upper front via V2' with the silicide layer C, if any, to form the front via FV'. Continuously, the BPR trench BT may be filled with the same via material(s), and planarized to form the BPR 150. The via material(s) may be filled in the lower via hole H1' and the BPR trench BT through, for example, CVD, PVD or PECVD.

Again, as the lower via hole H1' has a greater width or average width that the upper via hole H2' as describe in the previous step (S 110a), the lower front via V1' filled therein may have a greater width or average width and a greater aspect ratio than the upper front via V2', according to embodiments.

Thus, the BSPDN-based semiconductor device 40 including the front via FV' may be obtained as shown in FIG. 5F, and flipped upside down again as shown in FIG. 4 for further processing.

As described above, a front via may be obtained by forming vertically connected lower and upper via holes separately at different steps and filling a via material(s) therein continuously or at different steps. Thus, a via hole patterning (etching process) margin and a metal-fill margin may be increased. Further, the front via a back side overlay in manufacturing back side structures of a semiconductor device may also be facilitated, and via metal resistance characteristics may be improved.

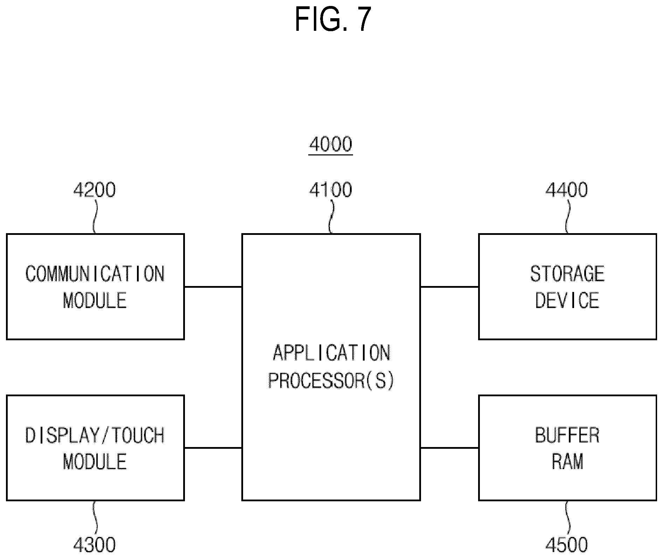

FIG. 7 is a schematic block diagram illustrating an electronic device including one or more BSPDN-based semiconductor devices as shown in FIGS. 1 and 4, according to an example embodiment.

Referring to FIG. 7, an electronic device 4000 may include at least one application processor 4100, a communication module 4200, a display/touch module 4300, a storage device 4400, and a buffer random access memory (RAM) 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 7, the electronic device 4000 may further include at least one sensor such as an image sensor. At least one component in the electronic device 4000 may include one or more of the BSPDN-based semiconductor devices 10 and 40 shown in FIGS. 1 and 4.

The foregoing is illustrative of exemplary embodiments and is not to be construed as limiting the inventive concept. Although a few exemplary embodiments have been described, those skilled in the art will readily appreciate that many modifications are possible in the above embodiments without materially departing from the inventive concept.

## Claims

1. A semiconductor device comprising:
at least one transistor, a front side structure, and a back side structure, the front side structure being disposed opposite to the back side structure with respect to the transistor; and
a front via formed at a side of the transistor and connecting the front side structure to the back side structure,
wherein the front via is formed in a via hole formed of a lower via hole and an upper via hole vertically connected to each other,
wherein the front via comprises a lower front via in the lower via hole and an upper front via in the upper via hole, and
wherein the via hole has a bent structure at a side surface thereof where the lower via hole is connected to the upper via hole.

2. The semiconductor device of claim 1, wherein a height of the lower via hole and a height of the upper via holes are substantially equal to each other.

3. The semiconductor device of claim 1 or 2, wherein an aspect ratio of the lower via hole is greater than an aspect ratio of the upper via hole.

4. The semiconductor device of any one of claims 1 to 3, wherein a bottom width of the upper front via is smaller than a top width of the lower front via.

5. The semiconductor device of any one of claims 1 to 4, wherein the transistor is a nanosheet transistor or a fin field-effect transistor, FinFET,
wherein a top surface of the lower front via is at a level substantially similar to or lower than a top surface of a shallow trench isolation, STI, structure formed at a side of the transistor, and
wherein the upper front via is laterally surrounded by an interlayer dielectric, ILD, structure.

6. The semiconductor device of any one of claims 1 to 5, wherein the front side structure is a source/drain region contact plug formed on a source/drain region of the transistor, and
wherein the back side structure is a back side power distribution network, BSPDN, structure.

7. The semiconductor device of any one of claims 1 to 6, wherein a connection surface is formed between the lower front via and the upper front via.

8. The semiconductor device of claim 7, wherein the connection surface comprises a silicide layer.

9. A method of manufacturing a semiconductor device, the method comprising operations:
(a) providing at least one transistor structure formed on a substrate at a side of which an isolation structure is formed;
(b) forming an ancillary layer on the transistor structure;
(c) forming a preliminary via hole at a side of the transistor structure, the preliminary via hole vertically penetrating the ancillary layer and the isolation structure;
(d) removing the ancillary layer at a side of the transistor structure, leaving a lower portion of the preliminary via hole in the isolation structure;
(e) filling the lower portion of the preliminary via hole with a sacrificial via structure;
(f) forming an isolation layer on the transistor structure;
(g) forming an upper via hole penetrating the isolation structure at a side of the transistor structure, and forming a lower via hole by removing the sacrificial via structure;
(h) forming an upper front via in the upper via hole, and forming a lower front via in the lower via hole; and
(i) forming a front side structure of the semiconductor device on the transistor structure to be connected to the upper front via, and forming a back side structure of the semiconductor device to be connected to the lower front via.

10. The method of claim 9, wherein the sacrificial via structure has etch selectivity against at least the isolation structure.

11. The method of claim 10, wherein the ancillary layer comprises a carbon-based material.

12. The method of claim 11, further comprising forming a protection layer on the sacrificial via structure before the forming the isolation structure on the transistor structure, and
wherein the protection layer is also penetrated when the isolation structure is penetrated to form the upper via hole.

13. The method of any one of claims 9 to 12, wherein the front side structure is a source/drain region contact plug formed on a source/drain region of the transistor structure, and
wherein the back side structure is a back side power distribution network, BSPDN, structure.

14. The method of any one of claims 9 to 13, wherein operation (g) comprises forming the upper via hole down to the sacrificial via structure, and continuously forming the lower via hole by removing the sacrificial via structure, thereby obtaining a via hole comprising the upper via hole and the lower via hole connected to each other, and
wherein, in operation (h), a via material is continuously deposited in the lower via hole and the upper via hole to form a front via comprising the lower front via and the upper front via vertically connected to each other in the via hole, and
wherein, in operation (i), the front side structure and the back side structure are connected to each other through the front via.

15. The method of any one of claims 9 to 14, wherein in operations (g) and (h), the upper via hole is formed and the upper front via is filled in the upper via hole, after which an intermediate semiconductor device obtained through operation (g), in which the upper front via is formed, is flipped upside down, and the lower via hole is formed by removing the sacrificial via structure, and the lower front via is filled in the lower via hole.
